(19) Europäisches Patentamt
European Patent Office
Office européen des brevets

(11) **EP 4 576 321 A1**

(12) **EUROPEAN PATENT APPLICATION**
published in accordance with Art. 153(4) EPC

(43) Date of publication:
**25.06.2025 Bulletin 2025/26**

(21) Application number: **23912905.9**

(22) Date of filing: **26.12.2023**

(51) International Patent Classification (IPC):
**H01M 10/48** (2006.01)    **H01M 10/42** (2006.01)

(52) Cooperative Patent Classification (CPC):
**H01M 10/42; H01M 10/48;** Y02E 60/10

(86) International application number:
**PCT/KR2023/021634**

(87) International publication number:
**WO 2024/144230 (04.07.2024 Gazette 2024/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **27.12.2022  KR 20220185631
19.12.2023  KR 20230185646**

(71) Applicant: **LG Energy Solution, Ltd.
Seoul 07335 (KR)**

(72) Inventors:
• **KIM, Sungho
  Daejeon 34122 (KR)**
• **KIM, Dong Hyun
  Daejeon 34122 (KR)**

(74) Representative: **Plasseraud IP
104 Rue de Richelieu
CS92104
75080 Paris Cedex 02 (FR)**

(54) **OVERHEATING DIAGNOSIS METHOD, AND OVERHEATING DIAGNOSIS APPARATUS AND BATTERY SYSTEM FOR PROVIDING SAME METHOD**

(57)    The present disclosure relates to an overheating diagnosis method, an overheating diagnosis apparatus, and a battery system providing the same. The overheating diagnosis apparatus includes: a measuring unit configured to measure a temperature of an object; a storage unit configured to store a temperature value measured by the measuring unit; and a control unit configured to extract, at each diagnosis point at which overheating of the object is diagnosed, a plurality of previous diagnosis points corresponding to a predetermined number of samples based on a diagnosis point, calculate a moving average value which is an average of a plurality of temperature values corresponding to each of the plurality of previous diagnosis points, and calculate an standard deviation average value which is an average of a plurality of standard deviations corresponding to each of the plurality of previous diagnosis points, wherein when an error value calculated by multiplying the standard deviation average value by a predetermined multiple is greater than or equal to a predetermined error reference value, the control unit is further configured to: calculate an overheating reference value by adding the error value to the moving average value, and diagnose an occurrence of an overheating event for the object by comparing the temperature value measured at each diagnosis point with the overheating reference value calculated at each diagnosis point.

FIG. 3

**Description**

**[Technical Field]**

CROSS-REFERENCE TO RELATED APPLICATION

This application claims priority to and the benefit of Korean Patent Application No. 10-2022-0185631 filed in the Korean Intellectual Property Office on December 27, 2022, and Korean Patent Application No. 10-2023-0185646 filed in the Korean Intellectual Property Office on December 19, 2023, the entire contents of which are incorporated herein by reference.

The present disclosure relates to a method of diagnosing overheating of an object (e.g., battery, etc.), and an overheating diagnosis apparatus and battery system providing the method.

**[Background Art]**

Recently, as the demand for portable electronic products such as a laptop, a video camera, and a portable phone, has rapidly increased, and as the development of electric vehicles, energy storage batteries, robots, and satellites begins in earnest, researches on high-performance batteries capable of repeated charging and discharging are actively underway.

Currently commercialized batteries include a nickel cadmium battery, a nickel hydrogen battery, a nickel zinc battery, a lithium battery, etc. Among them, since the lithium batteries have little memory effect compared to the nickel-based batteries, the lithium batteries may be freely charged and discharged, have a very low self-discharge rate, and have high energy density, so they are in the spotlight.

Meanwhile, a temperature of the battery is a factor that significantly affects performance of the battery. In general, the battery may operate efficiently when the temperature of the battery is distributed at an appropriate temperature. For example, when the temperature of the battery is too high, safety of an anode crystal lattice of the battery may decrease, which may lead to deterioration in the performance of the battery or accidents such as explosion. Therefore, it is necessary to accurately monitor the temperature of the battery.

In the related art, the overheating of the battery was diagnosed by comparing the measured temperature of the battery with a preset reference value. In the related art method, a time interval between when an overheating event is diagnosed and when the explosion, etc., of the battery occurs is too short, making it difficult to take appropriate measures. In addition, the related art method has a problem of misdiagnosing an increase in temperature due to aging of the battery as an overheating event.

**[Disclosure]**

**[Technical Problem]**

The present disclosure attempts to provide an overheating diagnosis method capable of diagnosing abnormal heating behavior (hereinafter referred to as overheating) of an object with high precision, and an overheating diagnosis apparatus and battery system providing the method.

**[Technical Solution]**

According to an aspect of the present disclosure, an overheating diagnosis apparatus may include: a measuring unit configured to measure a temperature of an object, a storage unit configured to store a temperature value measured by the measuring unit, and a control unit configured to extract, at each diagnosis point at which overheating of the object is diagnosed, a plurality of previous diagnosis points corresponding to a predetermined number of samples based on a diagnosis point, calculate a moving average value which is an average of a plurality of temperature values corresponding to each of the plurality of previous diagnosis points, and calculate an standard deviation average value which is an average of a plurality of standard deviations corresponding to each of the plurality of previous diagnosis points. Further, when an error value calculated by multiplying the standard deviation average value by a predetermined multiple is greater than or equal to a predetermined error reference value, the control unit is further configured to calculate an overheating reference value by adding the error value to the moving average value, and diagnose an occurrence of an overheating event for the object by comparing the temperature value measured at each diagnosis point with the overheating reference value calculated at each diagnosis point.

The control unit be further configured to correct the plurality of temperature values as a result of comparing each of the plurality of temperature values corresponding to the plurality of previous diagnosis points and the moving average value when the error value is less than the error reference value, and calculate the overheating reference value based on the plurality of corrected temperature values.

The control unit may be configured to correct the temperature value by adding a predetermined correction value to the temperature value when the temperature value is greater than the moving average value and subtracting the correction value from the temperature value when the temperature value is less than the moving average value, for each of the plurality of temperature values.

The control unit may be configured to, when the measured temperature value exceeds the overheating reference value diagnose that the overheating event has occurred in the object.

According to another aspect of the present disclosure, a battery system may include a battery including a plurality of battery cells, a measuring unit configured to measure a temperature of the battery, a storage unit configured to store a temperature value measured by the measuring unit, and a control unit configured to extract, at each diagnosis point at which overheating of the battery is diagnosed, a plurality of previous diagnosis points corresponding to a predetermined number of samples based on the diagnosis point, calculate a moving average value which is an average of a plurality of temperature values corresponding to each of the plurality of previous diagnosis points, and calculate an standard deviation average value which is an average of a plurality of standard deviations corresponding to each of the plurality of previous diagnosis points, wherein when an error value calculated by multiplying the standard deviation average value by a predetermined multiple is greater than or equal to a predetermined error reference value, the control unit is further configured to calculate an overheating reference value by adding the error value to the moving average value, and diagnose an occurrence of an overheating event for the battery by comparing the temperature value measured at each diagnosis point with the overheating reference value calculated at each diagnosis point.

The control unit may be further configured to correct the plurality of temperature values as a result of comparing each of the plurality of temperature values corresponding to the plurality of previous diagnosis points and the moving average value when the error value is less than the error reference value, and calculate the overheating reference value based on the plurality of corrected temperature values.

The control unit may be configured to correct the temperature value by adding a predetermined correction value to the temperature value when the temperature value is greater than the moving average value and subtracting the predetermined correction value from the temperature value when the temperature value is less than the moving average value, for each of the plurality of temperature values.

The control unit may be configured to, when the measured temperature value exceeds the overheating reference value, diagnose that the overheating event has occurred in the battery.

According to still another aspect of the present disclosure, an overheating diagnosis method may include a temperature data collection step of receiving a temperature value, which is a temperature measurement value of a battery, from a measuring unit at a predetermined diagnosis point at which overheating of the battery including a plurality of battery cells is diagnosed, a sample group determination step of extracting a plurality of previous diagnosis points corresponding to the number of samples based on the diagnosis point, an overheating reference value calculation step including calculating a moving average value which is an average of a plurality of temperature values corresponding to each of the plurality of previous diagnosis points, calculating an standard deviation average value which is an average of a plurality of standard deviations corresponding to each of the plurality of previous diagnosis points, calculating an error value by multiplying the standard deviation average value by a predetermined multiple, and when the calculated error value is greater than or equal to a predetermined error reference value, calculating an overheating reference value by adding the error value to the moving average value, and an overheating diagnosis step of diagnosing an occurrence of an overheating event for the battery by comparing the temperature value with the overheating reference value.

The overheating reference value calculation step may further includes, when the error value is less than the error reference value, a temperature value correction step of correcting the plurality of temperature values as a result of comparing each of the plurality of temperature values corresponding to the plurality of previous diagnosis points with the moving average value, and the overheating reference value may be calculated based on the plurality of corrected temperature values.

The temperature value correction step may include extracting the plurality of temperature values corresponding to each of the plurality of previous diagnosis points, comparing each of the plurality of temperature values with the moving average value, a first correction step of correcting the temperature value by adding a predetermined correction value to the temperature value when the temperature value is greater than or equal to the moving average value as a result of the comparison, and a second correction step of correcting the temperature value by subtracting the predetermined correction value from the temperature value when the temperature value is less than the moving average value.

The overheating diagnosis step may include comparing the measured temperature value and the overheating reference value, a first diagnosis step of diagnosing that the overheating event has occurred in the battery when the measured temperature value exceeds the overheating reference value as a result of the comparison, and a second diagnosis step of diagnosing the battery as a normal state in which no overheating event has occurred when the measured temperature value is less than or equal to the overheating reference value as a result of the comparison.

**[Advantageous Effects]**

Unlike the related art diagnosis method using a fixed reference value, according to the present disclosure, by calculating an overheating reference value that reflects a temperature trend for an object at each overheating diagnosis point and comparing the calculated overheating reference value with the measured temperature to perform the overheating diagnosis, it is possible to determine whether an overheating event occurs with high precision.

According to the present disclosure, by calculating an overheating reference value based on the moving average value and the standard deviation at each diagnosis point, it is possible to prevent the problem of misdiagnosing an increase in temperature due to aging of an object (ex, battery, etc.) as an occurrence of an overheating event.

According to the present disclosure, when the interval between the overheating reference value and the moving average value is significantly narrow, by correcting a plurality of temperature values that are the basis for calculating the overheating reference value, it is possible to remarkably improve the precision of the diagnosis.

**[Description of the Drawings]**

FIG. 1 is a block diagram illustrating an overheating diagnosis apparatus according to an embodiment.

FIG. 2 is a block diagram for describing a battery system according to another embodiment.

FIG. 3 is a flowchart describing an overheating diagnosis method according to an embodiment.

FIG. 4 is a flowchart describing in detail an overheating reference value determination step (S300) of FIG. 3.

FIG. 5 is a flowchart describing in detail a temperature value correction step (S370) of FIG. 4.

FIG. 6 is an exemplary diagram illustrating a temperature change of a defect-free battery in a charging mode.

FIG. 7 is an exemplary diagram illustrating a temperature change of a defective battery in the charging mode.

**[Mode for Invention]**

Hereinafter, embodiments of the present disclosure will be described in detail with reference to the accompanying drawings and the same or similar components are given the same reference numerals and are not repeatedly described. The suffix "module" and/or "unit" for components used in the following description is given or mixed in consideration of only the ease of writing of the specification, and therefore, do not have meanings or roles that distinguish from each other in themselves. Further, when it is decided that a detailed description for the known art related to the present disclosure may obscure the gist of the present disclosure, the detailed description will be omitted. Further, it should be understood that the accompanying drawings are provided only in order to allow exemplary embodiments of the present disclosure to be easily understood, and the spirit of the present disclosure is not limited by the accompanying drawings, but includes all the modifications, equivalents, and substitutions included in the spirit and the scope of the present disclosure.

Terms including an ordinal number such as first, second, etc., may be used to describe various components, but the components are not limited to these terms. The above terms are used solely for the purpose of distinguishing one component from another.

Further, in the present specification, it is to be understood that when one component is referred to as being "connected to" or "coupled to" another component, it may be connected or coupled directly to another component or be connected to another component with the other component interposed therebetween. On the other hand, it should be understood that when one element is referred to as being "connected directly to" or "coupled directly to" another element, it may be connected to or coupled to another element without the other element interposed therebetween.

It will be further understood that terms "include" or "have" used in the present specification specify the presence of features, numerals, steps, operations, components, parts mentioned in the present specification, or combinations thereof, but do not preclude the presence or addition of one or more other features, numerals, steps, operations, components, parts, or combinations thereof.

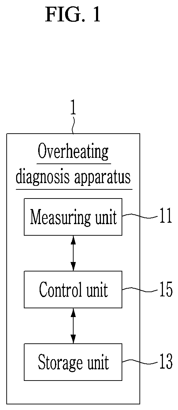

FIG. 1 is a block diagram illustrating an overheating diagnosis apparatus according to an embodiment.

Referring to FIG. 1, an overheating diagnosis apparatus 1 includes a measuring unit 11, a storage unit 13, and a control unit 15.

The measuring unit 11 may measure a temperature of an object at each point (hereinafter referred to as diagnosis point) at which overheating of the object is diagnosed and transmit a measurement result to the control unit 15. For example, the measuring unit 11 may include a temperature sensor that measures the temperature of the object. In this case, the object may include, but is not limited to, a battery, and may include various devices that need to be predicted in advance before an overheating event occurs.

The storage unit 13 may store a temperature value of the object measured by the measuring unit 11 at each diagnosis point. In addition, the storage unit 13 may store a moving average value MA, a standard deviation SD, a standard deviation average value SD_ave, and an overheating reference value Th that are calculated by the control unit 15 at each diagnosis point. For example, a temperature value T, the moving average value MA, the standard deviation SD, the standard deviation average value SD_ave, and the overheating reference value Th of the object corresponding to a certain diagnosis point may be stored in the storage unit 13 in the form of a lookup table.

When the diagnosis point according to a preset condition arrives, the control unit 15 calculates the moving average value MA and the overheating reference value Th that has a predetermined value greater than the moving average value. For example, when the object is a battery, the diagnosis point may be a point when charging of the battery starts or a point when discharging of the battery ends. However, the diagnosis point is not limited thereto, and may be variously set.

First, when counting diagnosis points in a direction of a previous diagnosis point based on a current diagnosis point N, the control unit 15 may extract a plurality of diagnosis points included in the preset number of samples SN to determine a sample group. In this case, the number of samples SN is the number of diagnosis points included in the sample group, and may be determined as the optimal number based on experiments, etc.

The sample group is a subgroup of a plurality of past diagnosis points, which is a population, and may be a group for calculating the moving average value MA and the standard deviation average value SD_ave, etc., which will be described below.

(Table 1)

| Diagnosis cycle | 1 | ... | N-5 | N-4 | N-3 | N-2 | N-1 | N |
|---|---|---|---|---|---|---|---|---|
| Temperature (T) | - | | 29.4 | 29.3 | 29.4 | 29.3 | 29.5 | $T_N$ |
| Moving average(MA) | - | | 29.37 | 29.36 | 29.35 | 29.37 | 29.36 | $MA_N$ |
| Standard deviation (SD) | - | | 0.0745 | 0.0744 | 0.0743 | 0.0744 | 0.0745 | $SD_N$ |
| Standard deviation average (SD_ave) | - | | 0.0740 | 0.0741 | 0.0740 | 0.0742 | 0.0742 | $SD_N$_ave |
| Error value(ER) | - | | 0.0766 | 0.0833 | 0.0866 | 0.1106 | 0.0466 | $ER_N$ |
| Overheating reference value(Th) | - | | 29.6 | 29.61 | 29.61 | 29.702 | 29.50 | $Th_N$ |
| Diagnosis result | - | | Normal | Normal | Normal | Normal | Normal | - |

Table 1 above shows an example of a lookup table for the temperature value T, the moving average value MA, the standard deviation SD, the standard deviation average value SD_ave, an error value ER, the overheating reference value Th, etc. Hereinafter, a method of calculating an overheating reference value $Th_N$ required for overheating diagnosis at an N-th diagnosis point will be described in detail. In addition, the number of samples SN is assumed to be 5. However, the number of samples SN is not limited thereto, and may be determined as various positive integers.

For reference, at first diagnosis point 1 in Table 1, there is no previous diagnosis point to constitute the sample group, so the moving average value MA, the standard deviation SD, the standard deviation average value SD_ave, and the overheating reference value Th may be difficult to calculate directly (therefore, the corresponding values in Table 1 are blank). In addition, since the number of previous diagnosis points to constitute the sample group is insufficient at predetermined diagnosis points (e.g., 2, 3, 4, and 5) adjacent to the first diagnosis point 1, it may be difficult to calculate the moving average value MA, the standard deviation SD, the standard deviation average value SD_ave, and the overheating reference value Th. In this case, a designer may provide values calculated on average according to the experiment to the moving average value MA, the standard deviation SD, the standard deviation average value SD_ave, and the overheating reference value Th at the initial diagnosis point and adjacent diagnosis points (e.g., 1, 2, 3, 4, and 5).

When counting the diagnosis points in the previous direction based on the N-th diagnosis point N which is the current diagnosis point, the control unit 15 may extract an N-1-th diagnosis point, an N-2-th diagnosis point, an N-3-th diagnosis point, an N-4-th diagnosis point, and an N-5-th diagnosis point corresponding to 5, which is the number of samples SN, to determine a sample group.

The control unit 15 may extract a plurality of diagnosis points N-1, N-2, N-3, N-4, and N-5 to determine the sample group, and calculate the overheating reference value $Th_N$ used for the overheating diagnosis based on temperature values measured at each of the plurality of diagnosis points N-1, N-2, N-3, N-4, and N-5 belonging to the sample group.

For example, when the object is the battery, if the battery is used for a long period of time, an internal resistance value increases due to aging, and the temperature may gradually rise as the internal resistance value increases. According to the embodiment, when the overheating of the battery is diagnosed based on the overheating reference value $Th_N$, it is possible to prevent the problem of misdiagnosing the temperature rise due to long-term use as the occurrence of the overheating event. In addition, it may solve the problem of misdiagnosing a temporary temperature rise as the occurrence of the overheating event.

Next, the control unit 15 calculates the overheating reference value $Th_N$ corresponding to the N-th diagnosis point based on the temperature value T measured at each of the plurality of diagnosis points N-1, N-2, N-3, N-4, and N-5 belonging to the sample group.

According to an embodiment, the control unit 15 compares a temperature value $T_N$ measured at the N-th diagnosis point with the overheating reference value $Th_N$ calculated at the N-th diagnosis point to diagnose whether the object is overheated. For example, referring to Table 1, a moving average value $MA_N$ and a standard deviation average value $SD_{N\_}$ave are values required to calculate the overheating reference value $Th_N$. The standard deviation $SD_N$ is not a value required when diagnosing an overheating condition at the N-th diagnosis point, but is necessary for determining overheating events at subsequent diagnosis points N+1, N+2, ..., and therefore, may be calculated and stored in the storage unit 13.

Hereinafter, referring to Table 1, the moving average value $MA_N$, the standard deviation $SD_N$, the standard deviation average value $SD_{N\_}$ave, an error value $ER_N$, and the overheating reference value $Th_N$ calculated by the control unit 15 at the N-th diagnosis point will be described.

The control unit 15 may average (29.4°C + 29.3°C + 29.4°C + 29.3°C +29.5°C/5 = 29.38°C) a plurality of temperature values 29.4°C, 29.3°C, 29.4°C, 29.3°C, and 29.5°C corresponding to each of the plurality of diagnosis points N-5, N-4, N-3, N-2, and N-1 belonging to the sample group to calculate the moving average value $MA_N$ (29.38°C) corresponding to the N-th diagnosis point N. That is, the moving average value $MA_N$ at the N-th diagnosis point may be calculated by the following Equation 1.

$$MA_N = \frac{T_{N-5} + T_{N-4} + T_{N-3} + T_{N-2} + T_{N-1}}{N}$$

Equation 1

Referring to Table 1 above and Table 2 below, the control unit 15 may calculate the standard deviation $SD_N$ corresponding to the N-th diagnosis point based on the temperature value T corresponding to each of the plurality of diagnosis points N-5, N-4, N-3, N-2, and N-1 belonging to the sample group and the moving average value $MA_N$ corresponding to the N-th diagnosis point N.

(Table 2)

| | N-5 | N-4 | N-3 | N-2 | N-1 | N |
|---|---|---|---|---|---|---|
| Temperature (T) | 29.4 | 29.3 | 29.4 | 29.3 | 29.5 | |
| $|T - MA_N|$ | $|29.4-29.38|$ | $|29.3-29.38|$ | $|29.4-29.38|$ | $|29.3-29.38|$ | $|29.5-29.38|$ | |
| $(T - MA_N)^2$ | $(0.02)^2 = 0.0004$ | $(0.08)^2 = 0.0064$ | $(0.02)^2 = 0.0004$ | $(0.08)^2 = 0.0064$ | $(0.12)^2 = 0.0144$ | |
| Variance | (0.0004+ 0.0064+ 0.0004+ 0.0064+ 0.0144)/5 = 0.0056 | | | | | |
| Standard deviation ($SD_N$) | $\sqrt{0.0056} = 0.0748331477 (\fallingdotseq 0.0748)$ | | | | | 0.0748 |

As described above, the standard deviation $SD_N$ corresponding to the N-th diagnosis point is not a value necessary when diagnosing the overheating condition at the N-th diagnosis point, but is necessary when diagnosing whether the overheating event of the object has occurred at the subsequent diagnosis points N+1, N+2, ...

Accordingly, the standard deviation $SD_N$ corresponding to the N-th diagnosis point may be calculated at the N-th diagnosis point and stored in the storage unit 13.

(Table 3)

| | N-5 | N-4 | N-3 | N-2 | N-1 | N |
|---|---|---|---|---|---|---|
| Standard deviation(SD) | 0.0745 | 0.0744 | 0.0743 | 0.0744 | 0.0745 | |
| Standard deviation average $(SD_{N\_ave})$ | (0.0745+ 0.0744+ 0.0743+ 0,0744+ 0.0745)/5 = 0.07442 | | | | | 0,07442 |

(Standard deviation, Standard deviation average)

Referring to Tables 1 and 3 above, the control unit 15 may calculate the standard deviation average value $SD_N\_ave$ (0.07442) corresponding to the N-th diagnosis point based on a plurality of standard deviations $SD_{N-5}$, $SD_{N-4}$, $SD_{N-3}$, $SD_{N-2}$, and $SD_{N-1}$ corresponding to each of the plurality of diagnosis points N-5, N-4, N-3, N-2, and N-1 belonging to the sample group.

The control unit 15 may calculate the overheating reference value $Th_N$ that is a predetermined value larger than the moving average value $MA_N$. First, the control unit 15 may calculate the error value $ER_N$ by multiplying the standard deviation average value $SD_N\_ave$ by a preset multiple $\alpha$ according to Equation 2 below. In this case, the multiple $\alpha$ is a value to reflect various errors, and may be determined as various values through the experiment. Hereinafter, the multiple $\alpha$ is assumed to be a natural number 3 ($\alpha$=3).

$$ER_N = SD_N\_ave \times \alpha\text{- Equation (2)}$$

For example, referring to Table 3 and Equation 2, the control unit 15 may calculate the error value $ER_N$, 0.22326 by multiplying the standard deviation average value $SD_N\_ave$ (0.07442) by the multiple $\alpha$, 3.

The error value $ER_N$ is a value that reflects errors that may occur in various situations, such as temperature measurement. When the error value $ER_N$ is very small, an interval between the moving average value $MA_N$ and the overheating reference value $Th_N$ may be very narrow. That is, even if no actual overheating event occurred, the misdiagnosis may occur that the overheating event occurs according to an arithmetic calculation in which the temperature value $T_N$ measured at the N-th diagnosis point exceeds the overheating reference value $Th_N$ calculated at the N-th diagnosis point. In other words, when the error value $ER_N$, which is the basis for calculating the overheating reference value $Th_N$, is smaller than the generally expected value, there is a high possibility of misdiagnosis.

According to an embodiment, when the error value $ER_N$ is greater than or equal to a predetermined error reference value $TH_N\_ER$, the control unit 15 may calculate the overheating reference value $Th_N$ by adding the error value $ER_N$ to the moving average value $MA_N$. Hereinafter, the error reference value $TH_N\_ER$ is assumed to be a value (29.38°C $\times$ 0.01 = 0.2938) corresponding to 1% of the moving average value $MA_N$, but is not limited thereto and may be determined as various values.

According to another embodiment, when the error value $ER_N$ is less than the error reference value $TH_N\_ER$, the control unit 15 corrects the temperature value T corresponding to each of the plurality of diagnosis points N-5, N-4, N-3, N-2, and N-1 belonging to the sample group. That is, the control unit 15 may correct temperature data corresponding to each of the plurality of diagnosis points N-5, N-4, N-3, N-2, and N-1 belonging to the sample group.

According to another embodiment, the control unit 15 may correct the temperature value T by adding a predetermined correction value $\beta$ to the temperature value T when the temperature value T corresponding to each of the plurality of diagnosis points N-5, N-4, N-3, N-2, and N-1 is greater than or equal to the moving average value $MA_N$. When the temperature value T corresponding to each of the plurality of diagnosis points N-5, N-4, N-3, N-2, and N-1 is less than the moving average value $MA_N$, the temperature value may be corrected by subtracting the correction value $\beta$ from the temperature value T. Hereinafter, the correction value $\beta$ is assumed to be 2, but is not limited thereto and may be determined as various values.

Referring to Equation 2 above, the error value $ER_N$ (0.22326) is smaller than the reference value $TH_N\_ER$ (0.2938). The control unit 15 may correct the plurality of temperature values 29.4°C, 29.3°C, 29.4°C, 29.3°C, and 29.5°C belonging to the sample group by calculating $\pm$ correction value $\beta$ =2 for each of the plurality of temperature values 29.4°C, 29.3°C, 29.4°C, 29.3°C, and 29.5°C corresponding to the plurality of diagnosis points N-5, N-4, N-3, N-2, and N-1 belonging to the sample group.

According to Equation 1, the moving average value $MA_N$ is 29.38°C. Specifically, since a temperature value $T_{N-5}$ (29.4°C) at the N-5-th diagnosis point is greater than or equal to the moving average value $MA_N$ (29.38°C), the control unit 15 may calculate a temperature value $T_{N-5}$ of 29.4 + 2 = 31.4°C at the processed N-5-th diagnosis point by adding the correction value β = 2 to the temperature value $T_{N-5}$ (29.4°C) at the N-5th diagnosis point. Since the temperature value $T_{N-4}$ (29.3°C) at the N-4-th diagnosis point is smaller than the moving average value $MA_N$ of 29.38°C, the control unit 15 may calculate the temperature value $T_{N-4}$ (29.3 - 2 = 27.3°C) by subtracting the correction value β = 2 from the temperature value $T_{N-4}$ (29.3°C) at the N-4-th diagnosis point. When correcting the temperature values 29.4°C, 29.3°C, and 29.5°C at the N-3-th diagnosis point, the N-2-th diagnosis point, and the N-1-th diagnosis point (N-3, N-2, and N-1), respectively, corrected temperature values T' for each of the plurality of diagnosis points N-5, N-4, N-3, N-2, and N-1 may be 31.4°C, 27.3°C, 31.4°C, 27.3°C, and 31.5°C.

When the temperature values at each of the plurality of diagnosis points N-5, N-4, N-3, N-2, and N-1 are corrected, the control unit 15 may again calculate a moving average value $MA_N'$, a standard average deviation value $SD_N$ ave', and an error value $ER_N'$ based on Equation 1, Equation 2, etc., based on the corrected temperature values T' 31.4°C, 27.3°C, 31.4°C, 27.3°C, and 31.5°C at each of the plurality of diagnosis points N-5, N-4, N-3, N-2, and N-1.

Next, the control unit 15 may calculate the overheating reference value $Th_N$ by adding the error value $ER_N$ to the moving average value $MA_N$ according to Equation 3 below.

$$Th_N = MA_N + ER_N \text{ -Equation (3)}$$

For example, when the temperature value T at each of the plurality of diagnosis points N-5, N-4, N-3, N-2, and N-1 is corrected, the control unit 15 may calculate the overheating reference value $Th_N$ based on the moving average value $MA_N'$ and the error value $ER_N'$ calculated based on the corrected temperature value T' at each of the plurality of diagnosis points N-5, N-4, N-3, N-2, and N-1. For example, the overheating reference value $Th_N$ calculated based on the corrected temperature value T' at each of the plurality of diagnosis points N-5, N-4, N-3, N-2, and N-1 is assumed to be 32.5°C.

Next, the control unit 15 may compare the temperature $T_N$ value measured at the N-th diagnosis point and the overheating reference value $Th_N$ calculated at the N-th diagnosis point to diagnose whether the overheating event has occurred for the object.

For example, referring to Table 1, assume that the temperature $T_N$ value measured at the N-th diagnosis point is 30°C. Since the temperature $T_N$ value (30°C) corresponding to the N-th diagnosis point is smaller than the overheating reference value $Th_N$ (32.5°C) corresponding to the N-th diagnosis point, the control unit 15 may diagnose that no overheating event has occurred. That is, the control unit 15 may diagnose that the temperature of the object is in a normal state.

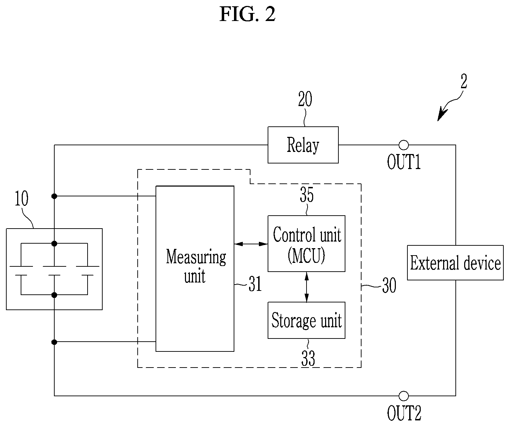

FIG. 2 is a block diagram for describing a battery system according to another embodiment.

Referring to FIG. 2, a battery system 2 includes a battery 10, a relay 20, and a battery management system (BMS) 30.

The battery 10 may include a plurality of battery cells connected in series and/or in parallel. In FIG. 2, three battery cells connected in parallel are illustrated, but the present disclosure is not limited thereto, and the battery 10 may include various numbers of battery cells connected in series and/or parallel. In some embodiments, the battery cell may be a rechargeable secondary battery.

In addition, for example, in the battery 10, a predetermined number of battery cells are connected in parallel to form a battery bank, and a predetermined number of battery banks are connected in series to form a battery pack, so that desired power may be supplied to an external device. As another example, in the battery 10, a predetermined number of battery cells are connected in parallel to form a battery bank, and a predetermined number of battery banks are connected in parallel to form a battery pack, so that desired power may be supplied to an external device. However, the present disclosure is not limited to this connection, and the battery 10 includes a plurality of battery banks including a plurality of battery cells connected in series and/or parallel, and the plurality of battery banks may also be connected in series and/or parallel.

In FIG. 2, the battery 10 is connected between two output terminals OUT1 and OUT2 of the battery system 2. In addition, a relay 20 is connected between a positive electrode of the battery system 2 and the first output terminal OUT1. The configurations illustrated in FIG. 2 and the connection relationship between the configurations are examples, and the present disclosure is not limited thereto.

The relay 20 controls an electrical connection between the battery system 2 and the external device. When the relay 20 is turned on, the battery system 2 and the external device are electrically connected to perform the charge or discharge. When the relay 20 is turned off, the battery system 2 and the external device are electrically separated. In this case, the external device may be a charger in a charging cycle in which the battery 10 is charged by supplying power to the battery 10, and may be a load in a discharging cycle in which the battery 10 discharges power to the external device.

The BMS 30 includes a measuring unit 31, a storage unit 33, and a control unit 35. The overheating diagnosis apparatus 1 illustrated in FIG. 1 may correspond to the BMS 30 illustrated in FIG. 2. Describing in detail, the functions performed by the measuring unit 11, the storage unit 13, and the control unit 15, respectively, of the overheating diagnosis apparatus 1 may correspond to functions performed by the measuring unit 31, the storage unit 33, and the control unit 35 of the BMS 30. For example, the overheating diagnosis apparatus 1 may be configured separately from the battery system 2. As another example, in the battery system 2 as illustrated in FIG. 2, the BMS 30 may perform the function of the overheating diagnosis apparatus 1.

Hereinafter, descriptions of the functions of each of the measuring unit 31, the storage unit 33, and the control unit 35 of the BMS 30 will be replaced with descriptions of the functions of the measuring unit 11, the storage unit 13, and the control unit 15, respectively, of the overheating diagnosis apparatus 1.

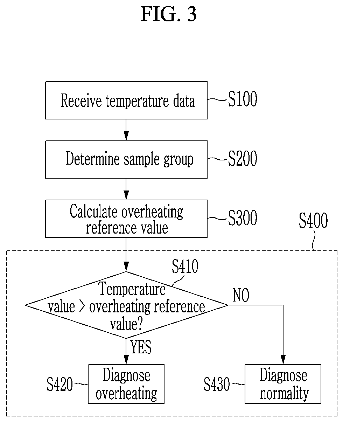

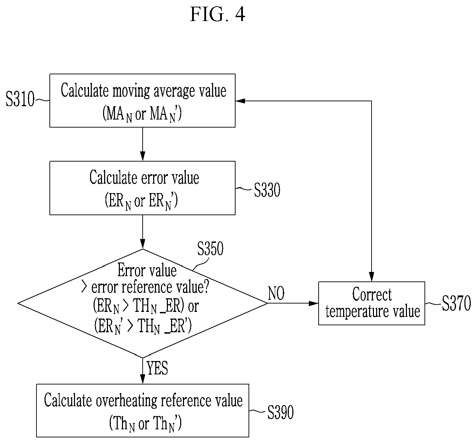

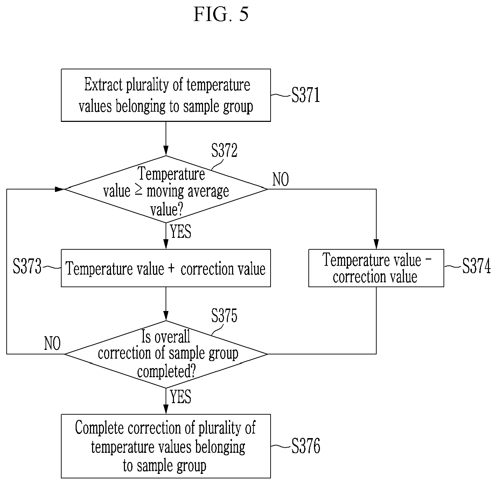

FIG. 3 is a flowchart describing an overheating diagnosis method according to an embodiment. FIG. 4 is a flowchart describing in detail an overheating reference value determination step (S300) of FIG. 3. FIG. 5 is a flowchart describing in detail a temperature value correction step (S370) of FIG. 4.

Hereinafter, referring to FIGS. 1 to 5, an overheating diagnosis method, and an overheating diagnosis apparatus 1 and a battery system 2 that provide the method will be described. Hereinafter, the measuring unit 31, the storage unit 33, and the control unit 35 of the BMS 30 will be described, which will be identically applied to the measuring unit 11, storage unit 13, and control unit 15 of the overheating diagnosis apparatus 1. In addition, although the battery 10 is described, the present disclosure is not limited thereto, and may be identically applied to various objects that require temperature measurement.

First, the control unit 35 receives temperature data including information on the measured temperature of the battery 10 from the measuring unit 31 at a predetermined diagnosis point at which the overheating of the battery 10 is diagnosed (S100). When diagnosis points according to preset conditions arrive, the measuring unit 31 may measure the temperature of the battery 10 and transmit the measured result to the control unit 35. For example, the measuring unit 31 may include a temperature sensor to measure the temperature of the battery 10 at each diagnosis point and transmit the measured results to the control unit 35. As another example, the measuring unit 31 may receive a temperature value that is a result of the temperature sensor measuring the temperature of the battery 10 at predetermined time intervals or in real time, extract temperature data corresponding to a predetermined diagnosis point, and transmit the extracted temperature data to the control unit 35.

Next, the control unit 35 extracts a plurality of previous diagnosis points corresponding to the number of samples SN based on a current diagnosis point N to determine a sample group (S200).

Referring to Table 1, when counting the diagnosis points in the previous direction based on an N-th diagnosis point N which is the current diagnosis point, the control unit 35 may extract an N-5-th diagnosis point, an N-4-th diagnosis point, an N-3-th diagnosis point, an N-2-th diagnosis point, and an N-1-th diagnosis point corresponding to 5, which is the number of samples SN, to determine a sample group.

The control unit 35 may extract a plurality of diagnosis points N-5, N-4, N-3, N-2, and N-1 to determine a sample group, and calculate an overheating reference value $Th_N$ used for diagnosis based on temperature values $T_{N-5}$, $T_{N-4}$, $T_{N-3}$, $T_{N-2}$, and $T_{N-1}$ measured at each of the plurality of diagnosis points N-5, N-4, N-3, N-2, and N-1 belonging to the sample group. By calculating the overheating reference value $Th_N$ using the method described below, it is possible to prevent the problem of misdiagnosing a temperature increase due to aging of the battery as the occurrence of an overheating event. In addition, it may solve the problem of misdiagnosing a temporary temperature rise due to various causes as the occurrence of the overheating event.

Next, the control unit 35 calculates the overheating reference value $Th_N$ corresponding to the N-th diagnosis point based on the temperature values $T_{N-5}$, $T_{N-4}$, $T_{N-3}$, $T_{N-2}$, and $T_{N-1}$ measured at each of the plurality of diagnosis points N-5, N-2, N-3, N-4, and N-1 belonging to the sample group (S300).

In step S300, referring to FIG. 4, the control unit 35 calculates a moving average value $MA_N$ corresponding to the N-th diagnosis point by averaging the plurality of temperature values corresponding to each of the plurality of diagnosis points belonging to the sample group. (S310).

Specifically, referring to Table 1, the control unit 35 may average (29.4°C + 29.3°C + 29.4°C + 29.3°C +29.5°C/5 = 29.38°C) a plurality of temperature values 29.4°C, 29.3°C, 29.4°C, 29.3°C, and 29.5°C corresponding to each of the plurality of diagnosis points N-5, N-4, N-3, N-2, and N-1 belonging to the sample group to calculate the moving average value $MA_N$ (29.38°C) corresponding to the N-th diagnosis point N.

In step S300, the control unit 35 calculates a standard deviation average value $SD_{N\_ave}$ by averaging a plurality of standard deviations corresponding to each of the plurality of diagnosis points belonging to the sample group, and calculates an error value $ER_N$ based on the standard deviation average value $SD_{N\_ave}$ (S330).

Specifically, referring to Table 3, the control unit 35 may calculate the standard deviation average value $SD_{N\_ave}$ (0.07442) corresponding to the N-th diagnosis point based on a plurality of standard deviations $SD_{N-5}$, $SD_{N-4}$, $SD_{N-3}$, $SD_{N-2}$, and $SD_{N-1}$ corresponding to each of the plurality of diagnosis points N-5, N-4, N-3, N-2, and N-1 belonging to the sample group.

The control unit 35 may calculate the error value $ER_N$ by multiplying the standard deviation average value SD$_N$_ave by a preset multiple α according to Equation 2 above. In this case, the multiple α may be determined as various values through experiment. Hereinafter, the multiple α is assumed to be a natural number 3 (α=3). For example, referring to Table 3 and Equation 2, the control unit 35 may calculate the error value ER$_N$, 0.22326 by multiplying the standard deviation average value SD$_N$_ave (0.07442) by the multiple α, 3.

In step S300, the control unit 35 compares the error value ER$_N$ with a predetermined error reference value TH$_N$_ER (S350).

The error value ER$_N$ is a value that reflects errors that may occur in various situations, such as temperature measurement. When the error value ER$_N$ is very small, an interval between the moving average value MA$_N$ and the overheating reference value Th may be very narrow. That is, even if no actual overheating event occurred, the misdiagnosis may occur that the overheating event occurs according to an arithmetic calculation in which the temperature T$_N$ value measured at the N-th diagnosis point exceeds the overheating reference value Th$_N$ calculated at the N-th diagnosis point. In other words, when the error value ER, which is the basis for calculating the overheating reference value Th, is smaller than the generally expected value, there is a high possibility of misdiagnosis.

In step S300, when the error value ER$_N$ is smaller than the error reference value TH$_N$_ER, the control unit 35 corrects the temperature value T corresponding to each of the plurality of diagnosis points N-5, N-4, N-3, N-2, and N-1 belonging to the sample group.

For example, the error reference value TH$_N$_ER may be calculated to be a value (29.38°C × 0.01 = 0.2938) corresponding to 1% of the moving average value MA$_N$, but is not limited thereto and may be determined as various values.

In step S370, referring to FIG. 4, the control unit 35 extracts the plurality of temperature values corresponding to each of the plurality of diagnosis points N-5, N-4, N-3, N-2, and N-1 belonging to the sample group (S371).

In step S370, the control unit 35 compares each of the plurality of temperature values with the moving average value MA$_N$ (S373).

For example, for each of the plurality of temperature values, the control unit 35 may determine whether the temperature value is greater than or equal to the moving average value MA$_N$.

In step S370, when the temperature value is greater than or equal to the moving average value MA$_N$ as a result of the comparison (S372, YES), the control unit 35 corrects the temperature value by adding a predetermined correction value β to the temperature value (S373).

In step S370, when the temperature value is smaller than the moving average value MA$_N$ as a result of the comparison (S372, NO), the control unit 35 corrects the temperature value by subtracting the predetermined correction value β from the temperature value (S374).

For example, referring to Table 1 above, the temperature value T may be corrected by adding the correction value β=2 to each of the temperature values 29.4°C, 29.4°C, and 29.5°C at the N-5-th diagnosis point, N-3-th diagnosis point, and N-1-th diagnosis point corresponding to the moving average value MA$_N$ (29.38°C) or greater among the the plurality of diagnosis points N-5, N-4, N-3, N-2, and N-1 belonging to the sample group. In addition, the temperature value T may be corrected by subtracting the correction value β=2 from each of the temperature values 29.3°C and 29.3°C at the N-4-th diagnosis point and the N-2-th diagnosis point, corresponding to less than the moving average value MA$_N$ (29.38°C) among the the plurality of diagnosis points N-5, N-4, N-3, N-2, and N-1 belonging to the sample group. Then, the temperature values 29.4°C, 29.3°C, 29.4°C, 29.3°C, and 29.5°C at each of the plurality of diagnosis points N-5, N-4, N-3, N-2, and N-1 may be corrected to 31.4°C, 27.3°C, 31.4°C, 27.3°C, and 31.5°C.

Referring to FIGS. 4 and 5, the control unit 35 may perform steps S310 and S330 again depending on corrected temperature values T' 31.4°C, 27.3°C, 31.4°C, 27.3°C, and 31.5°C at the plurality of diagnosis points N-5, N-4, N-3, N-2, and N-1 to calculate a corrected moving average value MA$_N$' and a corrected error value ER$_N$' again. As a result of the determination in step S350, when the corrected error value ER$_N$' is greater than a corrected error reference value TH$_N$_ER' (S350, YES), the following step S390 may be performed. That is, steps S370, S310, and S330 may be repeated until the determination result of step S350 is YES. In this case, the corrected error reference value TH$_N$_ER' may be calculated as a value corresponding to 1% of the corrected moving average value MA$_N$'.

In step S370, it is determined that the control unit 35 corrects all of the plurality of temperature values corresponding to each of the plurality of diagnosis points N-5, N-4, N-3, N-2, and N-1 belonging to the sample group (S375).

In step S370, when there is an uncorrected temperature value among the plurality of temperature values as a result of the determination (S375, NO), the control unit 35 repeats from step S372.

In step S370, when the correction is completed for all of the plurality of temperature values belonging to the sample group as a result of the determination (S375, YES), the control unit 35 may store, in the storage unit 32, a plurality of corrected temperature values T$_{N-5}$', T$_{N-4}$', T$_{N-3}$', T$_{N-2}$', and T$_{N-1}$' corresponding to each of the plurality of diagnosis points N-5, N-4, N-3, N-2, and N-1, belonging to the sample group and complete the correction (S376).

According to an embodiment, at the N-th diagnosis point, even if the temperature value is corrected according to step S370, the measurement is performed at each of the plurality of diagnosis points N-5, N-4, N-3, N-2, and N-1, so the plurality of temperature values 29.4°C, 29.3°C, 29.4°C, 29.3°C, and 29.5°C already stored in the storage unit 32 may not be corrected. That is, at the N-th diagnosis point, even if the temperature value is corrected according to step S370, only the corrected overheating reference value $Th_N$ may be calculated based on the corrected moving average value $MA_N'$ and the corrected error value $ER_N'$.

According to another embodiment, at the N-th diagnosis point, even if the temperature value is corrected according to step S370, the temperature value is measured at each of the plurality of diagnosis points N-5, N-4, N-3, N-2, and N-1, so the plurality of temperature values 29.4°C, 29.3°C, 29.4°C, 29.3°C, and 29.5°C already stored in the storage unit 32 may change to the plurality of corrected temperature values 31.4°C, 27.3°C, 31.4°C, 27.3°C, and 31.5°C. Therefore, when calculating moving average values $MA_{N+1}$, $MA_{N+2}$, etc. and corrected error values $ER_{N+1}$ + $ER_{N+2}$, etc., at N+1 diagnosis point, N+2 diagnosis point, etc., they may be calculated based on the plurality of temperature values corrected at the N-th diagnosis point.

In step S300, referring back to FIG. 4, the control unit 35 calculates the overheating reference value $Th_N$ or $Th_N'$ by adding the error value $ER_N$ or $ER_N'$ to the moving average value $MA_N$ or $MA_N'$ (S390).

For example, when the temperature value T of each of the plurality of diagnosis points N-5, N-4, N-3, N-2, and N-1 is corrected, the control unit 35 may calculate the corrected overheating reference value $Th_N$ by adding the calculated corrected moving average value $MA_N'$ and corrected error value $ER_N'$ calculated based on the corrected temperature value T' of each of the plurality of diagnosis points N-5, N-4, N-3, N-2, and N-1. For example, the corrected overheating reference value $Th_N'$ calculated based on the corrected temperature value T' at each of the plurality of diagnosis points N-5, N-4, N-3, N-2, and N-1 is assumed to be 32.5°C.

Next, referring back to FIG. 3, the control unit 35 diagnoses whether the overheating event has occurred in the battery 10 by comparing the temperature $T_N$ value measured at the N-th diagnosis point and the overheating reference value $Th_N$ (S400).

In step S400, the control unit 35 determines whether the temperature $T_N$ value measured at the N-th diagnosis point exceeds the overheating reference value $Th_N$ (S410).

In step S400, when the temperature $T_N$ value exceeds the overheating reference value $Th_N$ as a result of the determination (S410, Yes), the control unit 35 diagnoses that the overheating event has occurred in the battery 10 (S420).

In step S400, when the temperature $T_N$ value is less than or equal to the overheating reference value $Th_N$ as a result of the determination (S400, No), the control unit 35 diagnoses that the temperature of the battery 10 is in a normal state (S430).

For example, referring to Table 1, assume that the temperature $T_N$ value measured at the N-th diagnosis point is 30°C. Since the temperature $T_N$ value (30°C) corresponding to the N-th diagnosis point is smaller than the overheating reference value $Th_N$ (32.5°C) corresponding to the N-th diagnosis point, the control unit 35 may diagnose that no overheating event has occurred. That is, the control unit 35 may diagnose that the temperature of the object is in a normal state.

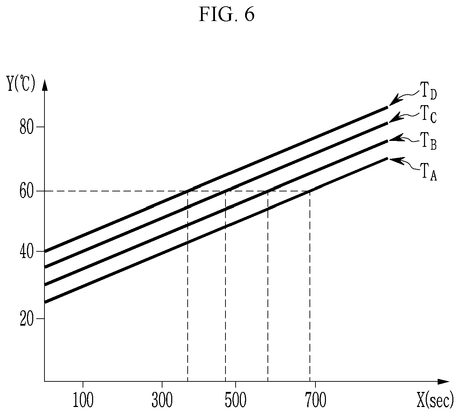

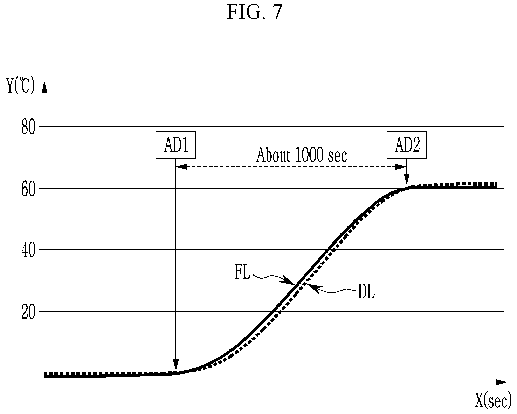

FIG. 6 is an exemplary diagram illustrating a temperature change of a defect-free battery in a charging mode. FIG. 7 is an exemplary diagram illustrating a temperature change of a defective battery in the charging mode.

In FIGS. 6 and 7, an X-axis represents time (sec), and a Y-axis represents temperature (°C).

Referring to FIG. 6, it is an exemplary diagram illustrating a temperature change over time when a defect-free battery is charged at various external temperatures.

For example, when air temperature is 25°C, in a charging mode in which the battery 10 is charged with power from an external device, the temperature change of the battery 10 over time may correspond to a first graph $T_A$. As another example, when the battery 10 is charged when the air temperature is 30°C, the temperature change of the battery 10 over time may correspond to a second graph $T_B$. Likewise, the temperature change of the battery 10 may correspond to a third graph $T_C$ and a fourth graph $T_D$ when the air temperature is 35°C and 40°C, respectively.

That is, in the case of a battery 10 in a normal state according to a predetermined standard or a new battery 10 unused, a starting temperature value may be different when the external temperature changes, but as illustrated in FIG. 6, the temperature change (i.e., slope) over time may be constant.

Referring to FIG. 7, it is an exemplary diagram illustrating the temperature change over time when a defective battery is charged at a predetermined external temperature.

In this case, a solid line FL is an actually measured temperature of the battery, and a dotted line DL drawn close to the solid line (FL) is a baseline. The baseline may be constructed by connecting the overheating reference values calculated at each diagnosis point according to the embodiment. Referring to FIGS. 6 and 7, the temperature change of the defect-free battery may form a straight line graph as illustrated in FIG. 6, but the temperature change of the defective battery may form a curved graph as illustrated in FIG. 7.

Conventionally, when the temperature of the battery 10 exceeds the fixed overheating reference value (for example, 60°C), the occurrence of the overheating event is diagnosed at that point. Referring to FIG. 7, conventionally, the occurrence of the overheating event of the battery 10 may be diagnosed for the first time at a second point AD2.

However, according to the overheating diagnosis method according to the embodiment, the occurrence of the overheating event may be diagnosed in advance before the temperature of the battery 10 exceeds the fixed overheating reference value (e.g., 60°C). As a result of the experiment, the occurrence of the overheating event for the battery 10 is diagnosed for the first time at a first point AD1. Specifically, as a result of the diagnosis, the overheating event is continuously diagnosed at each diagnosis point from the first point AD1 at which the solid line FL exceeded the dotted line DL to the second point AD2.

Referring to FIG. 7, the experimental results showed a time difference (about 16 minutes) of about 1000 sec between the first point AD1 and the second point AD2. According to the overheating diagnosis method according to the embodiment, the occurrence of the overheating event of the battery 10 may be known in advance, which has the advantage of being able to prepare countermeasures.

Although the embodiments of the present disclosure have been described in detail above, the scope of the present disclosure is not limited thereto, and various modifications and improvements by those of ordinary skill in the field to which the present disclosure pertains belong to the scope of the present disclosure.

**Claims**

1. An overheating diagnosis apparatus, comprising:

   a measuring unit configured to measure a temperature of an object;
   a storage unit configured to store a temperature value measured by the measuring unit; and
   a control unit configured to:

   extract, at each diagnosis point at which overheating of the object is diagnosed, a plurality of previous diagnosis points corresponding to a predetermined number of samples based on a diagnosis point,
   calculate a moving average value which is an average of a plurality of temperature values corresponding to each of the plurality of previous diagnosis points, and
   calculate an standard deviation average value which is an average of a plurality of standard deviations corresponding to each of the plurality of previous diagnosis points,
   wherein when an error value calculated by multiplying the standard deviation average value by a predetermined multiple is greater than or equal to a predetermined error reference value, the control unit is further configured to:

   calculate an overheating reference value by adding the error value to the moving average value, and
   diagnose an occurrence of an overheating event for the object by comparing the temperature value measured at each diagnosis point with the overheating reference value calculated at each diagnosis point.

2. The overheating diagnosis apparatus of claim 1, wherein the control unit is further configured to:

   correct the plurality of temperature values as a result of comparing each of the plurality of temperature values corresponding to the plurality of previous diagnosis points and the moving average value when the error value is less than the error reference value, and
   calculate the overheating reference value based on the plurality of corrected temperature values.

3. The overheating diagnosis apparatus of claim 2, wherein the control unit is configured to correct the temperature value by adding a predetermined correction value to the temperature value when the temperature value is greater than the moving average value and subtracting the correction value from the temperature value when the temperature value is less than the moving average value, for each of the plurality of temperature values.

4. The overheating diagnosis apparatus of claim 1, wherein when the measured temperature value exceeds the overheating reference value, the control unit is configured to diagnose that the overheating event has occurred in the object.

5. A battery system, comprising:

   a battery including a plurality of battery cells;
   a measuring unit configured to measure a temperature of the battery;
   a storage unit configured to store a temperature value measured by the measuring unit; and
   a control unit configured to:

extract, at each diagnosis point at which overheating of the battery is diagnosed, a plurality of previous diagnosis points corresponding to a predetermined number of samples based on the diagnosis point, calculate a moving average value which is an average of a plurality of temperature values corresponding to each of the plurality of previous diagnosis points, and
calculate an standard deviation average value which is an average of a plurality of standard deviations corresponding to each of the plurality of previous diagnosis points,
wherein when an error value calculated by multiplying the standard deviation average value by a predetermined multiple is greater than or equal to a predetermined error reference value, the control unit is further configured to:

calculate an overheating reference value by adding the error value to the moving average value, and diagnose an occurrence of an overheating event for the battery by comparing the temperature value measured at each diagnosis point with the overheating reference value calculated at each diagnosis point.

6. The battery system of claim 5, wherein the control unit is further configured to:

correct the plurality of temperature values as a result of comparing each of the plurality of temperature values corresponding to the plurality of previous diagnosis points and the moving average value when the error value is less than the error reference value, and
calculate the overheating reference value based on the plurality of corrected temperature values.

7. The battery system of claim 6, wherein the control unit is configured to correct the temperature value by adding a predetermined correction value to the temperature value when the temperature value is greater than the moving average value and subtracting the predetermined correction value from the temperature value when the temperature value is less than the moving average value, for each of the plurality of temperature values.

8. The battery system of claim 5, wherein when the measured temperature value exceeds the overheating reference value, the control unit is configured to diagnoses that the overheating event has occurred in the battery.

9. An overheating diagnosis method, comprising:

a temperature data collection step of receiving a temperature value, which is a temperature measurement value of a battery, from a measuring unit at a predetermined diagnosis point at which overheating of the battery including a plurality of battery cells is diagnosed;
a sample group determination step of extracting a plurality of previous diagnosis points corresponding to a number of samples based on the predetermined diagnosis point;
an overheating reference value calculation step including:

calculating a moving average value which is an average of a plurality of temperature values corresponding to each of the plurality of previous diagnosis points, calculating an standard deviation average value which is an average of a plurality of standard deviations corresponding to each of the plurality of previous diagnosis points,
calculating an error value by multiplying the standard deviation average value by a predetermined multiple, and
when the calculated error value is greater than or equal to a predetermined error reference value, calculating an overheating reference value by adding the error value to the moving average value; and

an overheating diagnosis step of diagnosing an occurrence of an overheating event for the battery by comparing the temperature value with the overheating reference value.

10. The overheating diagnosis method of claim 9, wherein the overheating reference value calculation step further includes: when the error value is less than the predetermined error reference value, a temperature value correction step of correcting the plurality of temperature values as a result of comparing each of the plurality of temperature values corresponding to the plurality of previous diagnosis points with the moving average value, and wherein the overheating reference value is calculated based on the plurality of corrected temperature values.

11. The overheating diagnosis method of claim 10, wherein the temperature value correction step includes:

extracting the plurality of temperature values corresponding to each of the plurality of previous diagnosis points;
comparing each of the plurality of temperature values with the moving average value;
a first correction step of correcting the temperature value by adding a predetermined correction value to the temperature value when the temperature value is greater than or equal to the moving average value as a result of the comparison; and
a second correction step of correcting the temperature value by subtracting the predetermined correction value from the temperature value when the temperature value is less than the moving average value.

12. The overheating diagnosis method of claim 9, wherein the overheating diagnosis step includes:

comparing the measured temperature value and the overheating reference value;
a first diagnosis step of diagnosing that the overheating event has occurred in the battery when the measured temperature value exceeds the overheating reference value as a result of the comparison; and
a second diagnosis step of diagnosing the battery as a normal state in which no overheating event has occurred when the measured temperature value is less than or equal to the overheating reference value as a result of the comparison.

FIG. 1

1

Overheating
diagnosis apparatus

| Measuring unit | — 11 |

| Control unit | — 15 |

| Storage unit | — 13 |

FIG. 2

## FIG. 3

| Receive temperature data | —S100 |

↓

| Determine sample group | —S200 |

↓

| Calculate overheating reference value | —S300 |

S400

S410

Temperature value > overheating reference value?

NO

YES

S420— | Diagnose overheating |

S430— | Diagnose normality |

FIG. 4

S310 — Calculate moving average value
($MA_N$ or $MA_N'$)

Calculate error value
($ER_N$ or $ER_N'$) — S330

S350

Error value
> error reference value?
($ER_N > TH_N\_ER$) or
($ER_N' > TH_N\_ER'$)

NO → Correct temperature value — S370

YES

Calculate overheating reference value
($Th_N$ or $Th_N'$) — S390

FIG. 5

Extract plurality of temperature values belonging to sample group —S371

S372
Temperature value ≥ moving average value?
NO

YES

S373— Temperature value + correction value

Temperature value − correction value —S374

S375
Is overall correction of sample group completed?
NO

YES

Complete correction of plurality of temperature values belonging to sample group —S376

FIG. 6

FIG. 7

## INTERNATIONAL SEARCH REPORT

| International application No. |
| --- |
| **PCT/KR2023/021634** |

| A. | CLASSIFICATION OF SUBJECT MATTER |
| --- | --- |

**H01M 10/48**(2006.01)i; **H01M 10/42**(2006.01)i

According to International Patent Classification (IPC) or to both national classification and IPC

| B. | FIELDS SEARCHED |
| --- | --- |

Minimum documentation searched (classification system followed by classification symbols)

H01M 10/48(2006.01); B60L 3/00(2006.01); B61K 9/06(2006.01); F26B 17/14(2006.01); F26B 25/00(2006.01); G01K 13/06(2006.01); G01R 31/367(2019.01); H03M 1/12(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 온도 (temperature), 센서 (sensor), 이동평균값 (moving average value), 제어 (control), 표준편차 (standard deviation)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2996240 B1 (TOYOTA MOTOR CORP.) 27 December 1999 (1999-12-27)<br>See claims 1 and 2; paragraphs [0016]-[0029]; and figure 1. | 1-12 |
| A | JP 2016-218053 A (CENTRAL JAPAN RAILWAY CO.) 22 December 2016 (2016-12-22)<br>See abstract; and claim 1. | 1-12 |
| A | JP 2001-208477 A (ISEKI & CO., LTD.) 03 August 2001 (2001-08-03)<br>See abstract; and claim 1. | 1-12 |
| A | KR 10-2020-0134580 A (KOREA ELECTRIC POWER CORPORATION) 02 December 2020 (2020-12-02)<br>See entire document. | 1-12 |
| A | KR 10-2021-0083460 A (SL CORPORATION) 07 July 2021 (2021-07-07)<br>See entire document. | 1-12 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **29 March 2024** | **02 April 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/021634**

| Patent document cited in search report | | | Publication date (day/month/year) | Patent family member(s) | | | Publication date (day/month/year) |
|---|---|---|---|---|---|---|---|
| JP | 2996240 | B1 | 27 December 1999 | JP | 2000-124806 | A | 28 April 2000 |
| JP | 2016-218053 | A | 22 December 2016 | JP | 6055149 | B2 | 27 December 2016 |
| JP | 2001-208477 | A | 03 August 2001 | JP | 4325053 | B2 | 02 September 2009 |
| KR | 10-2020-0134580 | A | 02 December 2020 | None | | | |
| KR | 10-2021-0083460 | A | 07 July 2021 | None | | | |

Form PCT/ISA/210 (patent family annex) (July 2022)

**REFERENCES CITED IN THE DESCRIPTION**

**Patent documents cited in the description**

- KR 1020220185631
- KR 1020230185646